# EUROPÄISCHE PATENTSCHRIFT

(11) **EP 2 092 557 B1**
(45) Veröffentlichungstag und Bekanntmachung des Hinweises auf die Patenterteilung: **22.06.2011**
(21) Anmeldenummer: 07822667.7
(22) Anmeldetag: 16.11.2007
(51) Int. Cl.: H01L 21/687, H01L 21/00

(54) **VERFAHREN UND ANORDNUNG ZUM THERMISCHEN BEHANDELN VON SUBSTRATEN**
METHOD AND ARRANGEMENT FOR HEAT TREATMENT OF SUBSTRATES
PROCÉDÉ ET SYSTÈME DE TRAITEMENT THERMIQUE DE SUBSTRATS

(30) Priorität: 17.11.2006 DE 102006054691
(43) Veröffentlichungstag der Anmeldung: 26.08.2009
(73) Patentinhaber: Centrotherm Thermal Solutions GmbH + CO. KG, 89143 Blaubeuren (DE)
(72) Erfinder: HARTUNG, Robert Michael, 89143 Blaubeuren (DE); VÖLLER, Hans Ulrich, 89143 Blaubeuren (DE)
(74) Vertreter: Lippert, Stachow & Partner
(86) Internationale Anmeldenummer: PCT/EP2007/062448
(87) Internationale Veröffentlichungsnummer: WO 2008/059049

(56) Entgegenhaltungen:
- WO-A-2005/106928
- WO-A1-2007/045444
- US-A1- 2006 219 360

## Beschreibung

Die Erfindung betrifft ein Verfahren zum thermischen Behandeln von Substraten, sowie eine Anordnung zur Durchführung des Verfahrens.

Bei der thermischen Behandlung von Substraten, z.B. Halbleiterwafern, Solarzellen, bestückten Leiterplatten usw. sowie anderen Elementen werden häufig RTP-Prozesse (RTP: Rapid Thermal Process), also Prozesse mit schnellen Temperaturänderungen eingesetzt, um den behandelten Materialien bestimmte Eigenschaften zu verleihen, oder zur Steuerung von Lötvorgängen oder um ganz einfach die Zeitdauer der thermischen Prozesse ganz drastisch zu verkürzen.

Die Heizung erfolgt üblicherweise mittels Strahlungsheizung und/oder einer Kühl-/Heizplatte, auf denen die zu behandelnden Substrate aufliegen oder in geringem ggf. variablem Abstand darüber angeordnet sind.

Bei der Behandlung von Substraten mit RTP-Prozessen müssen sehr hohe Rampraten der Temperaturänderung, möglichst auch mit einstellbarer Rampkurve, erreicht werden.

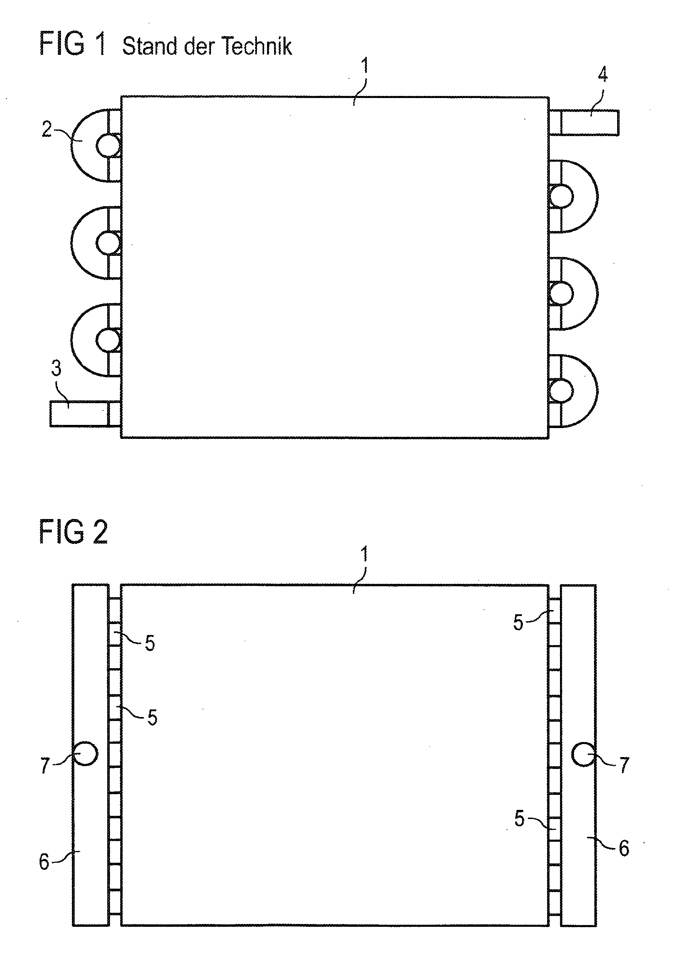

Um das zu erreichen, sind die Kühl-/Heizplatten 1, bestehend aus Messing, Aluminium, Edelstahl, Grauguss o.a., mit einem Kühlrohr 2 ausgestattet, das mäanderförmig durchgeschleift ist (Fig. 1, Stand der Technik) und durch das Druckluft oder Wasser geleitet wird. Dazu ist das Kühlrohr 2 mit einem Anschluss 3 für die Wasserzuführung und einem Anschluss 4 für die Wasserableitung versehen. Mit Druckluft läst sich eine Abkühlrate bis - 5 K/min und mit Wasser eine Abkühlrate von > 20 K/min erreichen.

Aus der DE 102 60 672 A1 geht ein Verfahren und eine Vorrichtung zum thermischen Behandeln von scheibenförmigen Substraten hervor, bei der eine von einem Fluid durchströmte Heiz/Kühlplatte zum Erwärmen bzw. Abkühlen eines Substrates vorgesehen ist. Das jeweilige Fluid kann dabei statisch innerhalb der Heiz/Kühlplatte gehalten werden, oder ständig dort hindurch geleitet werden, und zwar bei Bedarf insbesondere zum Abkühlen der Heiz/Kühlplatte.

Zwischen der Kühlung mit reiner Luft und der Kühlung mit Wasser liegt ein Bereich von Delta Temperatur von 15 K/min. Daraus ergibt sich das Problem, dass eine stufenlose Kühlung mit Rampraten im Bereich von -1 bis -100 K/min nicht erreicht werden kann. Darüber hinaus bietet die mäanderförmige Durchführung der Kühlrohre durch die Kühl-/Heizplatte keine akzeptable Homogenität der Temperaturverteilung über die Fläche der Platte auch im Hinblick auf höhere Löttemperaturen von über 450 °C. Mit der Mäanderkühlung wird eine Temperaturhomogenität von 150 °K über die Platte bei 650 °K erreicht.

Daraus ergibt sich die Aufgabe, ein Verfahren und eine Anordnung zur thermischen Behandlung von Substraten zu schaffen, mit der kontinuierlich einstellbare Abkühlraten über einen weiten Temperaturbereich bei gleichzeitig weitgehend homogener Temperaturverteilung über die Fläche der Heiz-/Kühlplatte erreicht werden können.

Die der Erfindung zugrunde liegende Aufgabe wird verfahrensgemäß dadurch gelöst, dass zwei Medien unterschiedlicher thermischer Leitfähigkeit gleichzeitig durch eine Kühl/Heizplatte geleitet werden, derart, dass ein erstes Medium hoher thermischer Leitfähigkeit während der Durchströmung der Kühl/Heizplatte von wenigstens einem zweiten Medium geringer thermischer Leitfähigkeit vollständig umgeben wird.

Im Falle der Verwendung der Kühl/Heizplatte als Heizplatte ist natürlich die erreichbare obere Temperatur vom ersten Medium abhängig, wohingegen bei der Verwendung der Kühl/Heizplatte als Kühlplatte selbstverständlich von weitaus höheren Temperaturen herabgekühlt werden kann, wie sie z.B. bei Lötprozessen auftreten.

In einer ersten Ausgestaltung der Erfindung ist die Strömungsgeschwindigkeit und Richtung beider Medien durch die Kühl/Heizplatte unabhängig voneinander einstellbar, so dass Rampraten im Bereich von -1 bis -100 K/min feinstufig erreichbar sind.

Das erste Medium hoher thermischer Leitfähigkeit ist eine Flüssigkeit, bevorzugt Wasser und das zweite Medium geringerer thermischer Leitfähigkeit ein Gas, bevorzugt Luft.

In einer speziellen Ausgestaltung der Erfindung wird das erste Medium vor der Einleitung in die Kühl/Heizplatte bedarfsweise entweder gekühlt oder erwärmt.

Eine weitere Ausgestaltung der Erfindung ist dadurch gekennzeichnet, dass die Kühl- oder Heizleistung stufenlos vom Minimum bis zum erreichbaren Maximum durch eine Volumensteuerung des zweiten Mediums gesteuert wird.

Schließlich ist vorgesehen, dass das erste Medium kontinuierlich oder gepulst durch die Kühl/Heizplatte geleitet wird.

Für den Fall, dass eine besonders hohe Abkühlgeschwindigkeit erreicht werden soll, wird das zweite Medium zumindest vorübergehend durch das erste Medium ersetzt.

Die der Erfindung zugrunde liegende Aufgabe wird ferner durch eine Vorrichtung gelöst, die dadurch gekennzeichnet ist, dass innerhalb einer Kühl/Heizplatte eine Vielzahl von Kühl/Heizrohren parallel zueinander verlaufend angeordnet sind, wobei jedes Kühl/Heizrohr aus einem Außenrohr, einem durchströmbaren Innenrohr und einem durchströmbaren Zwischenraum dazwischen besteht und dass jedes Innenrohr mit einer Zuführung für ein Medium einer ersten thermischen Leitfähigkeit und jeder Zwischenraum mit einer Zuführung für ein Medium einer zweiten thermischen Leitfähigkeit verbunden ist.

In einer Fortführung der Erfindung bestehen die Zuführungen für die Medien unterschiedlicher thermischer Leitfähigkeit jeweils aus einer Verteilereinrichtung mit Medienzuführung, so dass die Medien gleichmäßig über alle parallelen Kühlstränge verteilt werden.

Die Verteilereinrichtung für die Medien erster oder zweiter thermischer Leitfähigkeit weist einen trapezförmigen Innenraum auf, in dem ein ebenfalls trapezförmiger Volumenkörper mit geringeren Abmessungen angeordnet ist. Der Volumenkörper sorgt für eine gleichmäßige Verteilung der Medien in die Innenrohre bzw. die Zwischenräume zwischen dem jeweiligen Innen- und Außenrohr.

Schließlich ist das Innenrohr mit einer Wasserzuführung als Medium einer ersten thermischen Leitfähigkeit und der Zwischenraum mit einer Luftzuführung als Medium eine zweiten thermischen Leitfähigkeit verbunden.

Die Erfindung soll nachfolgend an einem Ausführungsbeispiel näher erläutert werden. In den zugehörigen Zeichnungsfiguren zeigen:
- Fig. 1:: eine Kühl/Heizplatte nach dem Stand der Technik;
- Fig. 2:: eine erfindungsgemäße Kühl/Heizplatte mit parallel geführten Kühl/Heizrohren;
- Fig. 3:: eine schematische Darstellung einer Einrichtung zur gleichmäßigen Verteilung von Luft und Wasser in den Kühl/Heizrohren nach Fig. 2; und
- Fig. 4:: eine schematische Darstellung eines Kühl/Heizrohres.

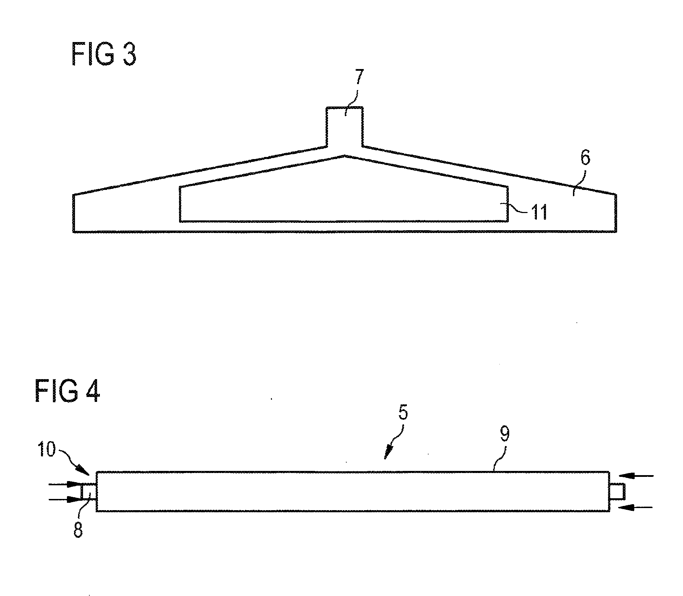

Erfindungsgemäß werden eine Vielzahl von Kühl/Heizrohren 5 in der Kühl/Heizplatte 1 parallel durchgeführt und das Heiz/Kühlmedium Wasser/Luft über eine Verteilereinrichtung 6 mit Medienzuführung 7 gleichmäßig über alle parallelen Kühlstränge verteilt. Um das zu erreichen, werden ummantelte Kühl/Heizrohre 5 eingesetzt, bei denen zwischen der Außenwand des Innenrohres 8 und dem Außenrohr 9 ein Zwischenraum 10 angeordnet ist (Fig. 4). Die zu kühlenden Substrate (nicht dargestellt), wie z.B. Silizium-Wafer o.dgl. liegen auf der Kühl/Heizplatte 1 auf.

Die Kühlung erfolgt hierbei durch Wasser, welches durch das Innenrohr 8 geleitet wird, wobei gleichzeitig eine Dämpfung der Kühlleistung dadurch vorgenommen wird, dass durch den Zwischenraum 10 Luft geleitet wird. Die grundlegende Idee ist also, die hohe Kühlleistung des Wassers (Medium mit einer ersten thermischen Leitfähigkeit) zu nutzen und mit Hilfe der Dämpfungswirkung der Luft (Medium mit einer zweiten thermischen Leitfähigkeit) auf die gewünschte Kühlleistung zu regulieren. Es versteht sich, dass auf die gleiche Art und Weise auch eine definierte Erwärmung realisiert bzw. unterstützt werden kann, indem entsprechend erwärmtes Wasser in das Innenrohr geleitet wird, wobei Heizen und Kühlen einander abwechseln können.

Für die gleichmäßige Verteilung von Luft und Wasser auf die parallel liegenden Kühl/Heizrohre 5 wird eine spezielle trapezförmige Verteilereinrichtung 6 mit innen befindlichem ebenfalls trapezförmigen Volumenkörper 11 mit geringeren Abmessungen eingesetzt (Fig. 3). Diese Verteilereinrichtung 6 überbrückt die parallelen Kühl/Heizrohre 5 auf beiden Seiten der Kühl-/Heizplatte (Fig. 2) und sorgt in sämtlichen Kühl/Heizrohren 5 für eine gleichförmige Wasserverteilung, so dass auf der gesamten Kühl/Heizplatte 1 eine gleichmäßige Temperaturverteilung erreicht wird.

Das Kühlmedium Wasser durchfließt dabei das Innenrohr 8 in einem gleichmäßigen Strom oder auch gepulst. Die durch den Zwischenraum 10 strömende Luft dämpft die Wärmeübertragung und dämpft somit die Kühlleistung des Wassers. Dadurch dass viele parallele Kühl/Heizrohre 5 eingesetzt werden, läst sich auch ein hoher Wasserdurchsatz realisieren, verbunden mit einer sehr hohen maximalen Kühlleistung. Die Durchströmung der beiden Medien durch die Kühl/Heizrohre 5 kann in gleicher oder entgegen gesetzter Richtung erfolgen.

Durch eine Volumensteuerung der Luft kann die Kühlleistung erfindungsgemäß stufenlos vom Minimum bis zum erreichbaren Maximum gesteuert werden.

Werden sehr hohe Abkühlraten gefordert, wird auch der Zwischenraum 10 um die Innenrohre 8 vollständig mit Wasser geflutet.

Mit der erfindungsgemäßen Lösung kann die Abkühlrate von -1 K/min bis -100 K/min kontinuierlich geregelt werden. Die Temperaturhomogenität über die Fläche der Heiz-/Kühlplatte beträgt ca. 35 K.

Ein besonderer Vorteil dieser Erfindung ist darin zu sehen, dass das Verfahren leicht beherrschbar ist und dass die Medien Wasser und (Druck-)Luft überall bei den Anwendern ohnehin vorhanden sind.

### Bezugszeichenliste

- 1: Kühl/Heizplatte
- 2: Kühlrohr
- 3: Anschluss
- 4: Anschluss
- 5: Kühl/Heizrohr
- 6: Verteilereinrichtung
- 7: Medienzuführung
- 8: Innenrohr
- 9: Außenrohr
- 10: Zwischenraum
- 11: Volumenkörper

## Patentansprüche

1. Verfahren zum thermischen Behandeln von Substraten mittels einer Kühl/Heizplatte, **dadurch gekennzeichnet, dass** zwei Medien unterschiedlicher thermischer Leitfähigkeit gleichzeitig durch die Kühl/Heizplatte geleitet werden, derart, dass ein erstes Medium hoher thermischer Leitfähigkeit während der Durchströmung der Kühl/Heizplatte von wenigstens einem zweiten Medium geringer thermischer Leitfähigkeit vollständig umgeben wird.

2. Verfahren nach Anspruch 1, **dadurch gekennzeichnet, dass** die Strömungsgeschwindigkeit und Richtung beider Medien durch die Kühl/Heizplatte unabhängig voneinander einstellbar sind.

3. Verfahren nach Anspruch 1 und 2, **dadurch gekennzeichnet, dass** als erstes Medium hoher thermischer Leitfähigkeit eine Flüssigkeit verwendet wird.

4. Verfahren nach Anspruch 3, **dadurch gekennzeichnet, dass** als erstes Medium Wasser verwendet wird.

5. Verfahren nach Anspruch 1 und 2, **dadurch gekennzeichnet, dass** als zweites Medium geringerer thermischer Leitfähigkeit ein Gas verwendet wird.

6. Verfahren nach Anspruch 5, **dadurch gekennzeichnet, dass** als zweites Medium Luft verwendet wird.

7. Verfahren nach einem der Ansprüche 1 bis 6, **dadurch gekennzeichnet, dass** das erste Medium vor der Einleitung in die Kühl/Heizplatte gekühlt oder erwärmt wird.

8. Verfahren nach einem der Ansprüche 1 bis 7, **dadurch gekennzeichnet, dass** die Kühl- oder Heizleistung stufenlos vom Minimum bis zum erreichbaren Maximum durch eine Volumensteuerung des zweiten Mediums gesteuert wird.

9. Verfahren nach einem der Ansprüche 1 bis 8, **dadurch gekennzeichnet, dass** das erste Medium kontinuierlich oder gepulst durch die Kühl/Heizplatte geleitet wird.

10. Verfahren nach einem der Ansprüche 1 bis 4, **dadurch gekennzeichnet, dass** das zweite Medium zumindest vorübergehend durch das erste Medium ersetzt wird.

11. Vorrichtung zum thermischen Behandeln von Substraten mittels einer Kühl/Heizplatte, **dadurch gekennzeichnet, dass** innerhalb der Kühl/Heizplatte (1) eine Vielzahl von Kühl/Heizrohren (5) parallel zueinander verlaufend angeordnet sind, wobei jedes Kühl/Heizrohr (5) aus einem Außenrohr (9), einem durchströmbaren Innenrohr (8) und einem durchströmbaren Zwischenraum (10) dazwischen besteht und dass jedes Innenrohr (8) mit einer Zuführung für ein Medium einer ersten thermischen Leitfähigkeit und jeder Zwischenraum (10) mit einer Zuführung für ein Medium einer zweiten thermischen Leitfähigkeit verbunden ist.

12. Vorrichtung nach Anspruch 11, **dadurch gekennzeichnet, dass** die Zuführungen für die Medien unterschiedlicher thermischer Leitfähigkeit jeweils aus einer Verteilereinrichtung (6) mit Medienzuführung (7) bestehen, so dass die Medien gleichmäßig über alle parallelen Kühlstränge verteilt werden.

13. Vorrichtung nach Anspruch 12, **dadurch gekennzeichnet, dass** die Verteilereinrichtung (6) für die Medien erster oder zweiter thermischer Leitfähigkeit einen trapezförmigen Innenraum aufweist, in dem ein ebenfalls trapezförmiger Volumenkörper (11) mit geringeren Abmessungen angeordnet ist.

14. Vorrichtung nach den Ansprüchen 11 bis 13, **dadurch gekennzeichnet, dass** das Innenrohr (8) mit einer Wasserzuführung als Medium einer ersten thermischen Leitfähigkeit und der Zwischenraum (11) mit einer Luftzuführung als Medium eine zweiten thermischen Leitfähigkeit verbunden ist.

## Claims

1. Method for thermal treatment of substrates by means of a cooling/heating plate, **characterised in that** two media of different thermal conductivity are simultaneously passed through the cooling/heating plate in such a way that a first medium of high thermal conductivity is fully enclosed by at least a second medium of low thermal conductivity while flowing through the cooling/heating plate.

2. Method according to claim 1, **characterised in that** the flow rate and direction of the two media through the cooling/heating plate are adjustable independently of one another.

3. Method according to either claim 1 or claim 2, **characterised in that** a liquid is used as the first medium of high thermal conductivity.

4. Method according to claim 3, **characterised in that** water is used as the first medium.

5. Method according to either claim 1 or claim 2, **characterised in that** a gas is used as the second medium of low thermal conductivity.

6. Method according to claim 5, **characterised in that** air is used as the second medium.

7. Method according to any one of claims 1 to 6, **characterised in that** the first medium is cooled or heated prior to introduction into the cooling/heating plate.

8. Method according to any one of claims 1 to 7, **characterised in that** the cooling or heating power is controlled in a continuously variable manner, from the minimum to the maximum which can be attained, by controlling the volume of the second medium.

9. Method according to any one of claims 1 to 8, **characterised in that** the first medium is passed through the cooling/heating plate continuously or in a pulsed manner.

10. Method according to any one of claims 1 to 4, **characterised in that** the second medium is at least temporarily replaced by the first medium.

11. Device for thermal treatment of substrates by means of a cooling/heating plate, **characterised in that** a plurality of cooling/heating tubes (5) are arranged extending parallel to one another within the cooling/heating plate (1), each cooling/heating tube (5) consisting of an outer tube (9), an inner tube (8) which can be flowed through and an intermediate space (10) between them which can be flowed through, and **in that** each inner tube (8) is connected to a supply means for a medium of a first thermal conductivity and each intermediate space (10) is connected to a supply means for a medium of a second thermal conductivity.

12. Device according to claim 11, **characterised in that** the supply means for the media of different thermal conductivity each consist of a distributor device (6) comprising media supply means (7), in such a way that the media are distributed uniformly across all of the parallel cooling lines.

13. Device according to claim 12, **characterised in that** the distributor device (6) for the media of first or second thermal conductivity has a trapezium-shaped inner space in which a volume body (11) which is also trapezium-shaped but has smaller dimensions is arranged.

14. Device according to claims 11 to 13, **characterised in that** the inner tube (8) is connected to a water supply as the medium of a first thermal conductivity and the intermediate space (11) is connected to an air supply as the medium of a second thermal conductivity.

## Revendications

1. Procédé de traitement thermique de substrats au moyen d'une plaque de refroidissement/chauffage,
**caractérisé en ce qu'**
on transfère simultanément deux milieux de conductibilités thermiques différentes au travers de la plaque de refroidissement/chauffage, de sorte qu'un premier milieu de conductibilité thermique supérieure soit totalement entouré au cours de son écoulement au travers de la plaque de refroidissement/chauffage, par au moins un second milieu de conductibilité thermique plus faible.

2. Procédé conforme à la revendication 1,
**caractérisé en ce que**
la vitesse et le sens d'écoulement des deux milieux au travers de la plaque de refroidissement/chauffage, peuvent être réglés indépendamment.

3. Procédé conforme à la revendication 1 et à la revendication 2,
**caractérisé en ce qu'**
en tant que premier milieu de conductibilité thermique supérieure, on utilise un liquide.

4. Procédé conforme à la revendication 3,
**caractérisé en ce qu'**
en tant que premier milieu, on utilise de l'eau.

5. Procédé conforme à la revendication 1 et à la revendication 2,
**caractérisé en ce qu'**
en tant que second milieu de conductibilité thermique plus faible, on utilise un gaz.

6. Procédé conforme à la revendication 5,
**caractérisé en ce qu'**
en tant que second milieu, on utilise de l'air.

7. Procédé conforme à l'une des revendications 1 à 6,
**caractérisé en ce que**
le premier milieu est refroidi ou chauffé avant son entrée dans la plaque de refroidissement/ chauffage.

8. Procédé conforme à l'une des revendications 1 à 7,
**caractérisé en ce que**
la puissance de refroidissement ou de chauffage, est commandée en continu d'un minimum à un maximum pouvant être atteint par une commande du volume du second milieu.

9. Procédé conforme à l'une des revendications 1 à 8,
**caractérisé en ce que**
le premier milieu est transféré en continu ou de manière pulsée au travers de la plaque de refroidissement/chauffage.

10. Procédé conforme à l'une des revendications 1 à 4,
**caractérisé en ce que**
le second milieu est remplacé au moins temporairement par le premier milieu.

11. Dispositif de traitement thermique de substrats au moyen d'une plaque de refroidissement/chauffage,
**caractérisé en ce que**
la plaque de refroidissement/chauffage (1), comporte à sa partie interne un ensemble de tubes de refroidissement/chauffage (5) s'étendant parallèlement les uns aux autres, chacun de ces tubes de refroidissement/chauffage (5), étant constitué d'un tube extérieur (9), d'un tube intérieur (8) permettant l'écoulement et d'un espace intermédiaire (10) permettant l'écoulement et **en ce que** chaque tube interne (8) est relié à une alimentation en un premier milieu ayant une première conductibilité thermique et chaque espace intermédiaire (10) est relié à une alimentation en un milieu ayant une seconde conductibilité thermique.

12. Dispositif conforme à la revendication 11,
**caractérisé en ce que**
les alimentations en milieux ayant des conductibilités thermiques différentes, sont respectivement constituées par un dispositif de répartition (6) ayant une alimentation en milieu (7), de sorte que les milieux soient répartis uniformément sur toutes les branches de refroidissement parallèles.

13. Dispositif conforme à la revendication 12,
**caractérisé en ce que**
le dispositif de répartition (6) des milieux ayant une première ou une seconde conductibilité thermique comporte un espace interne trapézoïdal dans lequel est disposé un corps volumique (11) également de forme trapézoïdale de plus faible dimension.

14. Dispositif conforme aux revendications 11 à 13,
**caractérisé en ce que**
le tube intérieur (8) est relié à une alimentation en eau, constituant le milieu ayant une première conductibilité thermique et l'espace intermédiaire (11) est relié à une alimentation en air, constituant le milieu ayant une seconde conductibilité thermique.
